# EUROPEAN PATENT SPECIFICATION

(11) **EP 1 365 888 B1**
(45) Date of publication and mention of the grant of the patent: **07.03.2007**
(21) Application number: 01952962.7
(22) Date of filing: 29.06.2001
(51) Int. Cl.: B24B 37/04, B24B 41/047, B24B 47/10

(54) **PROJECTED GIMBAL POINT DRIVE**
PROJIZIERTER KARDANISCHER ANTRIEBSPUNKT
COMMANDE DE POINTS DE CARDAN PROJETE

(30) Priority: 01.07.2000 US 215666 P
(43) Date of publication of application: 03.12.2003
(73) Proprietor: LAM RESEARCH CORPORATION, Fremont, CA 94568 (US)
(72) Inventor: HALLEY, David, G., Los Osos, CA 93402 (US)
(74) Representative: Thomson, Paul Anthony
(86) International application number: PCT/US2001/041232
(87) International publication number: WO 2002/002276

(56) References cited:
- EP-A- 0 119 989
- EP-A- 0 706 854
- US-A- 5 423 558

## Description

### BACKGROUND OF THE INVENTION

### 1. Field of the Invention

This invention relates generally to drive mechanisms for gimbal projection systems in a wafer polishing environment, as per the preamble of claims 1 and 8. Examples of such systems are disclosed by EP 706 854 A.

### 2. Description of the Related Art

In the fabrication of semiconductor devices, there is a need to perform Chemical Mechanical Polishing (CMP) operations, including polishing, buffing and wafer cleaning. Typically, integrated circuit devices are in the form of multi-level structures. At the substrate level, transistor devices having diffusion regions are formed. In subsequent levels, interconnect metallization lines are patterned and electrically connected to the transistor devices to define the desired functional device. Patterned conductive layers are insulated from other conductive layers by dielectric materials, such as silicon dioxide. As more metallization levels and associated dielectric layers are formed, the need to planarize the dielectric material increases.

Without planarization, fabrication of additional metallization layers becomes substantially more difficult due to the higher variations in the surface topography. In other applications, metallization line patterns are formed in the dielectric material, and then metal CMP operations are performed to remove excess metallization. Further applications include planarization of dielectric films deposited prior to the metallization process, such as dielectrics used for shallow trench isolation or for poly-metal insulation.

In the CMP process, the gimbal point of a CMP substrate carrier is a critical element. The substrate carrier must align itself to the polish surface precisely to insure uniform, planar polishing results. Many CMP substrate carriers currently available yield wafers having anomalies in planarity. The vertical height of the pivot point above the polishing surface is also important, since the greater the height, the larger the moment that is induced about the pivot point during polishing. Two pervasive problems that exist in most CMP wafer polishing apparatuses are underpolishing of the center of the wafer, and the inability to adjust the control of wafer edge exclusion as process variables change.

For example, substrate carriers used on many available CMP machines experience a phenomenon known in the art as "nose diving". During polishing, the head reacts to the polishing forces in a manner that creates a sizable moment, which is directly influenced by the height of the gimbal point, mentioned above. This moment causes a pressure differential along the direction of motion of the head. The result of the pressure differential is the formation of a standing wave of the chemical slurry that interfaces the wafer and the abrasive surface. This causes the edge of the wafer, which is at the leading edge of the substrate carrier, to become polished faster and to a greater degree than the center of the wafer.

The removal of material on the wafer is related to the chemical action of the slurry. As slurry is inducted between the wafer and the abrasive pad and reacts, the chemicals responsible for removal of the wafer material gradually become exhausted. Thus, the removal of wafer material further from the leading edge of the substrate carrier (i.e., the center of the wafer) experiences a diminished rate of chemical removal when compared with the chemical action at the leading edge of the substrate carrier (i.e., the edge of the wafer), due to the diminished activity of the chemicals in the slurry when it reaches the center of the wafer.

Apart from attempts to reshape the crown of the substrate carrier, other attempts have been made to improve the aforementioned problem concerning "nose diving". In a prior art substrate carrier that gimbals through a single bearing at the top of the substrate carrier, sizable moments are generated because the effective gimbal point of the substrate carrier exists at a significant, non-zero distance from the surface of the polishing pad. Thus, the frictional forces, acting at the surface of the polishing pad, act through this distance to create the undesirable moments.

Further, the need for torsional drives that connect the gimbal to the driving spindle have proved unsuccessful in reducing the "nose diving" effect. In particular, using a single, or other direct drive means causes a force moment above the wafer that again causes "nose diving." Moreover, drive pins are a source of backlash, since a pin needs to be free in a hole to allow pivoting.

In view of the foregoing, there is a need for a gimbal based torsion drive that is capable of driving a wafer without causing the wafer edges to dig into the on coming polishing pad. The drive should allow the wafer to be driven rotationally yet still pivot to allow for non-alignment of the rotational axis with the contact surface of the wafer being driven. The closest prior art is provided by European Patent No. EP 0 706 854. However, whilst such prior art discloses a projected gimbal point system, it does not disclose the use of a drive cup sandwiched between the spindle and the wafer carrier.

### SUMMARY OF THE INVENTION

Broadly speaking, the present invention fills these needs by providing a drive mechanism that permits torque and axial force to be transmitted to a wafer being polished, not withstanding that the plane of the wafer might not be exactly perpendicular to the axis of rotation of the driving spindle. Thus, the drive mechanism allows the wafer to tilt about a gimbal point located on the surface of the wafer. In one embodiment, a projected gimbal point drive system according to claim 1 is disclosed. The projected gimbal point drive system includes a spindle capable of applying a torque, and further having a concave spherical surface formed on its lower portion. Also included is a wafer carrier disposed partially within the lower portion of the spindle. The wafer carrier has a convex spherical surface formed on a surface opposite the concave spherical surface of the spindle. In addition, a drive cup is included that is disposed between the spindle and the wafer carrier. The drive cup has a concave inner surface and a convex outer surface, and allows the wafer carrier to be tilted about a predefined gimbal point. The gimbal point can be located on an interface between a polishing pad and a surface of a wafer held by the wafer carrier. Further, the gimbal point can be intentionally located above ("nose diving") or below (skiing") the interface between a polishing pad and a surface of a wafer held by the wafer carrier if desired.

In another embodiment, a projected gimbal point drive cup according to claim 8 is disclosed. The projected gimbal point drive cup includes a first set of elongated slots located in a convex outer surface of the drive cup, and a second set of elongated slots located in a concave inner surface of the drive cup. The drive cup allows a wafer carrier to be tilted about a predefined gimbal point. A first set of drive keys extending out of a concave spherical surface of a spindle can be used to extend into the first set of slots in the drive cup. Similarly, a second set of drive keys extending out of a convex spherical surface of the wafer carrier can extend into the second set of slots of the drive cup. Optionally, the first set of slots can comprise two elongated slots, which are separated by about 180 degrees around the circumference of the drive cup. Similarly, the second set of slots can comprise two elongated slots, which also are separated by about 180 degrees around the circumference of the drive cup. Further, the first set of slots can be located about ninety degrees around an axis of symmetry of the drive cup from the second set of elongated slots.

Advantageously, the embodiments of the present invention can be configured such that the spherical shape and concentricity of the surface of the lower part of the drive spindle and surface of the wafer carrier assure that the wafer can tilt only about an axis that lies in the plane of the wafer-pad interface. If the axis about which the wafer tilts lies above or below the wafer-pad interface, forces are generated that push one sector of the wafer into the polishing pad more strongly than the diametrically opposite sector of the wafer is pushed, resulting in undesirable effects. The embodiments of the present invention allow these forces to be reduced, eliminated, or employed deliberately in a controlled manner to produce a desired result. Other aspects and advantages of the invention will become apparent from the following detailed description, taken in conjunction with the accompanying drawings, illustrating by way of example the principles of the invention.

### BRIEF DESCRIPTION OF THE DRAWINGS

The invention, together with further advantages thereof, may best be understood by reference to the following description taken in conjunction with the accompanying drawings in which:
Figure 1 is a simplified schematic diagram of an exemplary chemical mechanical planarization (CMP) system in accordance with one embodiment of the present invention;
Figure 2 is an illustration showing a wafer carrier mechanism having a projected gimbal point drive, in accordance with an embodiment of the present invention;
Figure 3 is side elevation cross sectional view A-A through the wafer carrier mechanism intersecting along an axis of rotation of the spindle; and
Figure 4 is side elevation cross sectional view B-B through the wafer carrier mechanism intersecting along an axis of rotation of the spindle.

### DETAILED DESCRIPTION OF THE PREFERRED EMBODIMENTS

An invention is disclosed for a projected gimbal point drive. To this end, the present invention provides a drive isolation cup that permits torque and axial force to be transmitted to a wafer being polished, not withstanding that the plane of the wafer might not be exactly perpendicular to the axis of rotation of the driving spindle. In the following description, numerous specific details are set forth in order to provide a thorough understanding of the present invention. It will be apparent, however, to one skilled in the art that the present invention may be practiced without some or all of these specific details. In other instances, well known process steps have not been described in detail in order not to unnecessarily obscure the present invention.

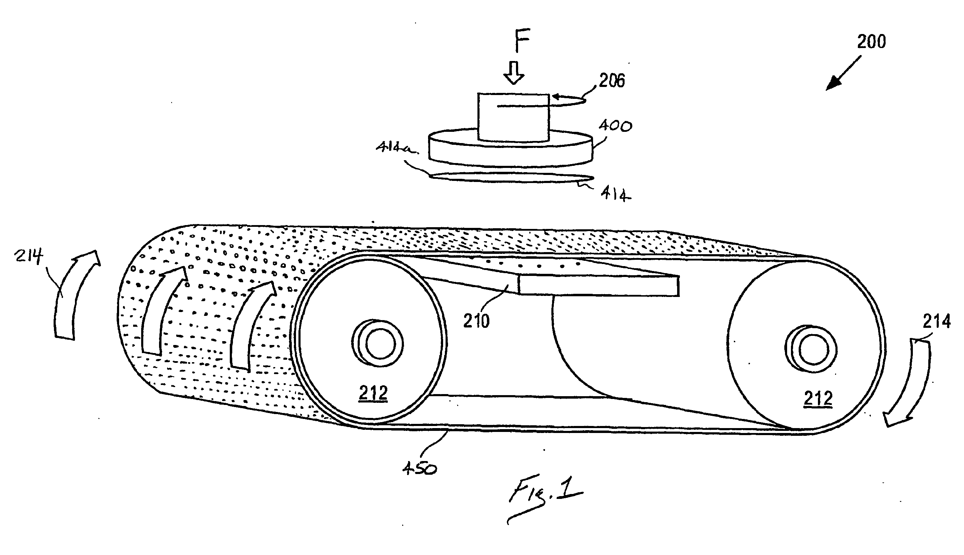

Figure 1 is a simplified schematic diagram of an exemplary chemical mechanical planarization (CMP) system in accordance with one embodiment of the present invention. As shown in Figure 1, CMP system 200 is a fixed abrasive CMP system, so designated because the preparation surface is an endless fixed abrasive material belt 450. Fixed abrasive material belt 450 is mounted on two drums 212, which drive the belt in a rotational motion in the direction indicated by arrows 214.

Wafer 414 is mounted on wafer carrier mechanism 400, which is rotated in direction 206. To carry out a planarization process, rotating wafer 414 is applied against the rotating fixed abrasive material belt 450 with a force F. As is well known to those skilled in the art, the force F may be varied to meet the demands of particular planarization processes. Platen 210, which is disposed below fixed abrasive material belt 450, stabilizes the belt and provides a solid surface onto which wafer 414 may be applied. Using the fixed abrasive material belt 450, the topographic features of wafer 414 activate the micro-replicated features of fixed abrasive material belt 450. Wafer carrier mechanism 400 is configured to prevent significant activation of the micro-replicated features of fixed abrasive material belt 450 by leading edge 414a of wafer 414, as will explained in more detail below. Thus, when the topographic features of wafer 414 are planarized, there are no remaining topographic features to activate the micro-replicated features of fixed abrasive material belt 450. As a result, the material removal rate slows by one or more orders of magnitude, thereby providing the CMP process with an automatic stopping characteristic referred to herein as "self-stopping."

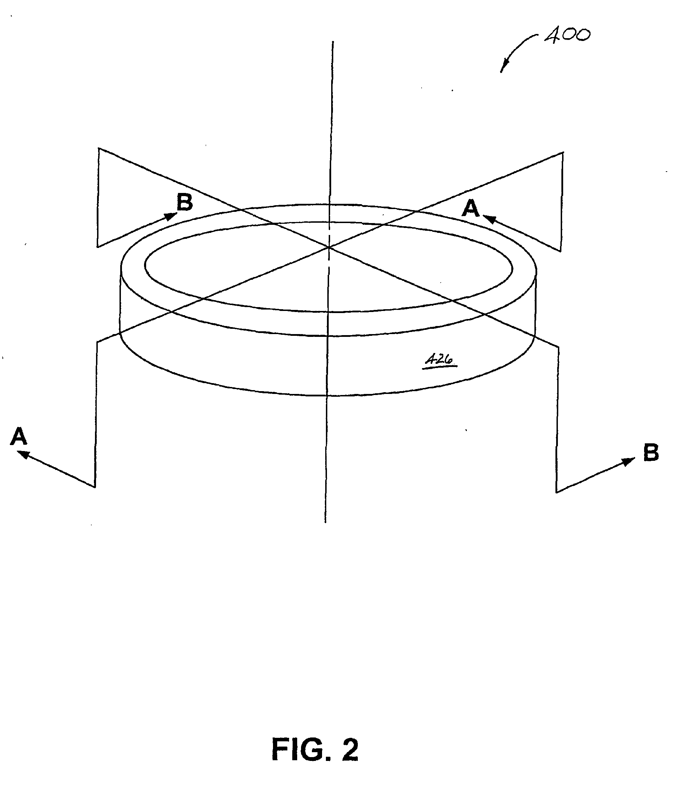

Figure 2 is an illustration showing a wafer carrier mechanism 400 having a projected gimbal point drive, in accordance with an embodiment of the present invention. In one embodiment, the projected gimbal point drive is a drive isolation cup, disposed within the lower portion 426 of a spindle, which permits torque and axial force to be transmitted to a wafer being polished. The drive isolation cup of the present invention is capable of transmitting he torque and axial force to the wafer not withstanding that the plane of the wafer might not be exactly perpendicular to the axis of rotation of the driving spindle, and by extension, the wafer carrier.

As discussed in greater detail subsequently, the geometry of the drive isolation cup is such that the wafer may tilt in any direction about a gimbal point located on the interface between the polishing pad and the surface of the wafer that is being polished. In this manner, embodiments of the present invention are capable of avoiding undesirable forces being applied perpendicular to the wafer, which are caused by locating the gimbal point in other locations.

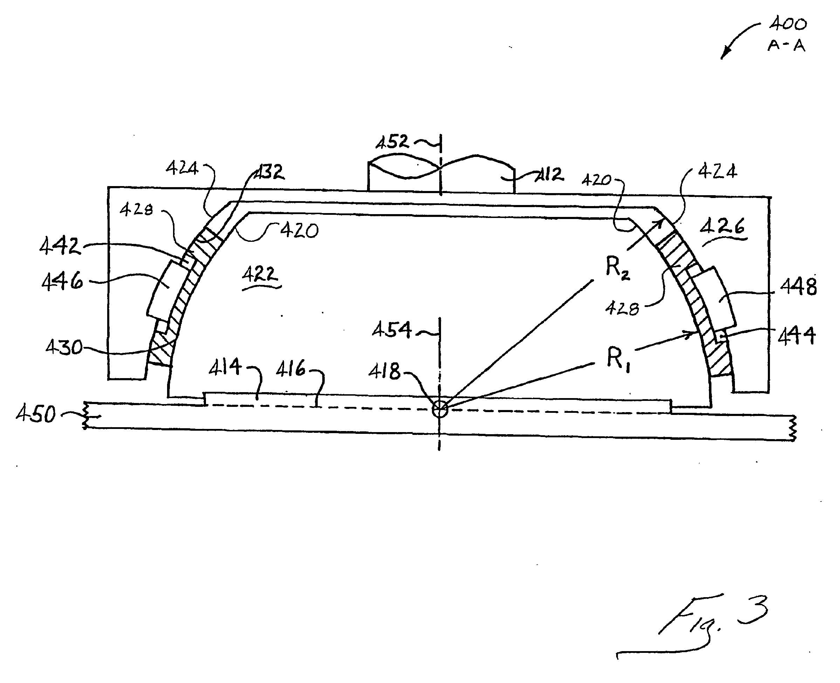

Figure 3 is side elevation cross sectional view A-A through the wafer carrier mechanism 400 intersecting along an axis of rotation of the spindle. It should be noted that the axis of rotation of the driving spindle shown in Figure 3 is an ideal situation wherein the axis of rotation is coinciding with a line perpendicular to the wafer, through the center of the wafer.

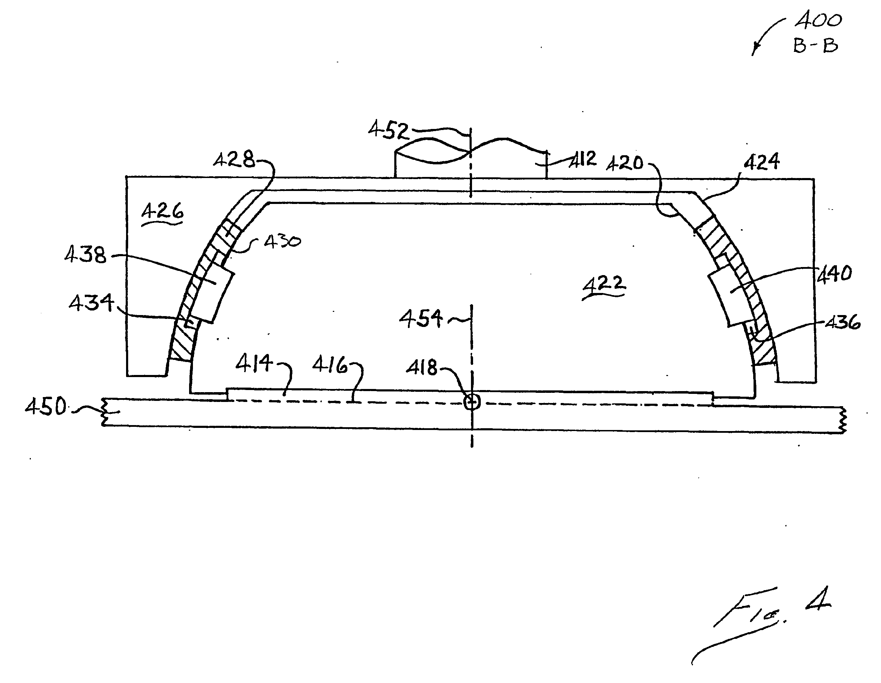

The wafer carrier mechanism 400 includes a lower part 426 of the spindle 412 coupled to a wafer carrier 422 via drive cup 428. Drive keys 446 and 448 are used to transmit torque, as are drive keys 438 and 440, discussed subsequently with respect to Figure 4. A polishing belt 450, disposed below the wafer carrier 422, is used to polish the surface of the wafer 414 during a CMP process. In operation, the drive spindle 412 applies a torque and a downward force to push the lower surface of the wafer 414 against the polishing pad 450.

In spite of efforts to achieve perfect alignment, a line 454 perpendicular to the wafer might deviate from being exactly parallel to the axis of rotation 452 of the spindle 412. The embodiments of the present invention advantageously accommodate this misalignment. To this end, the embodiments of the present invention locate the wafer 414 at such an elevation that any tilting of the wafer 414 from a position perpendicular to the spindle axis 452 occurs about a line that lies on the wafer-pad interface 416. In addition, some embodiments can locate the wafer 414 at such an elevation that any tilting of the wafer 414 from a position perpendicular to the spindle axis 452 occurs about a line that lies parallel to the wafer-pad interface 416, but spaced above or below the interface by a pre-selected distance.

As shown in Figure 3, a convex spherical surface 420 is formed on the wafer carrier 422. The convex spherical surface 420 has a radius R₁ from a point 418 at the center of the wafer 414 on the wafer-pad interface 416. From the same point 418, a concave spherical surface 424 of radius R₂ is formed on a lower part 426 of the driving spindle 412. It should be noted that the radius R₁ and radius R₂ can alternatively extend from a point at the center of the wafer 414 above the wafer-pad interface 416, or below the wafer-pad interface 416, depending on design requirements.

Disposed between the convex spherical surface 420 of the wafer carrier 422 and the concave spherical surface 424 of the lower part 426 of the drive spindle 412 is a drive cup 428. The drive cup 428 is generally ring-shaped and has a concave inner spherical surface 430 of radius R₁ and a convex outer spherical surface 432 of radius R₂. Formed in the convex outer spherical surface 432 of the drive cup 428 are two vertically elongated slots 442 and 444, which are separated by about 180 degrees around the circumference of the drive cup 428. Two drive keys 446 and 448 extend out of the concave spherical surface 424 of the lower portion 426 of the drive spindle 412. The drive keys 446 and 448 extend into the slots 442 and 444 of the drive cup 428, respectively, to transmit torque. The slots 442 and 444 are longer than the drive keys 446 and 448 to accommodate tilting movement between the lower portion 426 of the drive spindle 412 and the drive cup 428.

Figure 4 is side elevation cross sectional view B-B through the wafer carrier mechanism 400 intersecting along an axis of rotation of the spindle. As in Figure 3, it should be noted that the axis of rotation of the driving spindle shown in Figure 4 is an ideal situation wherein the axis of rotation is coinciding with a line perpendicular to the wafer, through the center of the wafer.

As shown in Figure 4, two vertically elongated slots 434 and 436 are formed in the concave inner spherical surface 430 of the drive cup 428. Similar to slots 442 and 444, slots 434 and 436 are separated by about 180 degrees around the circumference of the drive cup 428. Two drive keys 438 and 440 extend out of the convex spherical surface 420 of the wafer carrier 422. The drive keys 438 and 440 extend into the elongated slots 434 and 436 of the drive cup 428, respectively, to transmit torque. Further, the drive keys 438 and 440 are spaced about 90 degrees from the drive keys 446 and 448 around the axis of symmetry of the drive cup 428. As above, the slots 434 and 436 are longer than the drive keys 438 and 440 to accommodate tilting movement between the wafer carrier 422 and the drive cup 428.

Advantageously, the embodiments of the present invention can be configured such that the spherical shape and concentricity of the surface 420 of the lower part 426 of the drive spindle 412 and surface 424 of the wafer carrier assure that the wafer 414 can tilt only about an axis that lies in the plane of the wafer-pad interface 416. If the axis about which the wafer 414 tilts lies above or below the wafer-pad interface 416, forces are generated that push one sector of the wafer 414 into the polishing pad 450 more strongly than the diametrically opposite sector of the wafer 414 is pushed, resulting in undesirable effects. The embodiments of the present invention allow these forces to be reduced, eliminated, or employed deliberately in a controlled manner to produce a desired result.

Although the foregoing invention has been described in some detail for purposes of clarity of understanding, it will be apparent that certain changes and modifications may be practiced within the scope of the appended claims. Accordingly, the present embodiments are to be considered as illustrative and not restrictive, and the invention is not to be limited to the details given herein, but may be modified within the scope of the appended claims.

## Claims

1. A projected gimbal point drive system (400), comprising:
a spindle (412) capable of applying a torque, the spindle having a concave spherical surface (424) formed on a lower portion of the spindle (426) and a first set of drive keys (446, 448) extending out of the concave spherical surface (424);
a wafer carrier (422) disposed partially within the lower portion of the spindle (426), the wafer carrier having a convex spherical surface (420) formed on a surface opposite the concave spherical surface of the spindle (424); **characterized by**
a drive cup (428) disposed between the lower portion of the spindle (426) and the wafer carrier (422), the drive cup having a concave inner surface (430) and a convex outer surface (432), the drive cup further having a first set of elongated slots (442, 444) located in the convex outer surface of the drive cup, wherein the first set of drive keys (446, 448) extend into the elongated slots thereby allowing the wafer carrier (422) to be tilted about a predefined gimbal point.

2. A projected gimbal point drive system (400) as recited in claim 1, wherein the gimbal point is located on an interface (416) between a polishing pad (450)and a surface of a wafer (414) held by the wafer carrier (422).

3. A projected gimbal point drive system (400) as recited in claim 1, wherein the gimbal point is located below an interface (416) between a polishing pad (450) and a surface of a wafer (414) held by the wafer carrier (422).

4. A projected gimbal point drive system (400) as recited in claim 1, wherein the gimbal point is located above an interface (416) between a polishing pad (450) and a surface of a wafer (414) held by the wafer carrier (422).

5. A projected gimbal point drive system (400) as recited in claim 1, wherein the drive cup (428) includes a second set of elongated slots (434, 436) located in the concave inner surface (430) of the drive cup.

6. A projected gimbal point drive system as recited in claim 5, further comprising a second set of drive keys (438, 440) extending out of the convex spherical surface (420) of the wafer carrier (422).

7. A projected gimbal point drive system as recited in claim 6, wherein the second set of drive keys (438, 440) extend into the second set of drive slots (434, 436) of the drive cup.

8. A projected gimbal point drive cup (428), **characterized by**
a first set of elongated slots (442, 444) located in a convex outer surface (432) of the drive cup, wherein, in use, a first set of drive keys (446, 448) extending out of a concave spherical surface (424) of a spindle extend into the first set of slots in the drive cup; and
a second set of elongated slots (434, 436) located in a concave inner surface (430) of the drive cup, wherein, in use, a second set of drive keys (438, 440) extending out of a convex spherical surface (420) of a wafer carrier extend into the second set of slots of the drive cup; and
wherein the drive cup (428) allows the wafer carrier (422) to be tilted about a predefined gimbal point.

9. A projected gimbal point drive cup (428) as recited in claim 8, wherein the first set of slots (442, 444) comprises two elongate slots.

10. A projected gimbal point drive cup (428) as recited in claim 9, wherein the two elongated slots of the first set of slots are separated by about 180 degrees around the circumference of the drive cup.

11. A projected gimbal point drive cup (428) as recited in claim 10, wherein the second set of slots (434, 436) comprises two elongated slots.

12. A projected gimbal point drive cup (428) as recited in claim 11, wherein the two elongated slots of the second set of slots are separated by about 180 degrees around the circumference of the drive cup.

13. A projected gimbal point drive cup (428) as recited in claim 12, wherein the first set of slots are located about ninety degrees around an axis of symmetry of the drive cup from the second set of elongated slots.

## Patentansprüche

1. System (400) mit einem projizierten kardanischen Antriebspunkt, umfassend:
eine Spindel (412), die in der Lage ist, ein Drehmoment aufzubringen, wobei die Spindel eine in ihrem unteren Bereich (426) ausgebildete konkave kugelförmige Fläche (424) und einen ersten Satz Antriebskeile (446, 448) umfasst, die sich aus der konkaven kugelförmigen Fläche (424) hinaus erstrecken;
einen teilweise innerhalb des unteren Bereichs der Spindel (426) angeordneten Waferträger (422), wobei der Waferträger eine konvexe kugelförmige Fläche (420) aufweist, die auf einer Fläche ausgebildet ist, die der konkaven kugelförmigen Fläche der Spindel gegenüberliegt, **gekennzeichnet durch**
eine zwischen dem unteren Bereich (426) der Spindel und dem Waferträger (422) angeordnete Antriebsschale (428), wobei die Antriebsschale eine konkave Innenfläche (430) und eine konvexe Außenfläche (432) aufweist, wobei die Antriebsschale ferner einen ersten Satz langgestreckter Schlitze (442, 444) aufweist, die in der konvexen Außenfläche der Antriebsschale angeordnet sind, und wobei sich der erste Satz Antriebskeile (446, 448) in die langgestreckten Schlitze hinein erstreckt, wodurch dem Waferträger (422) ermöglicht wird, um einen vorbestimmten kardanischen Punkt gekippt zu werden.

2. System (400) mit einem projizierten kardanischen Antriebspunkt nach Anspruch 1, bei dem der kardanische Punkt auf einer Grenzfläche (416) zwischen einem Polierkissen (450) und der Oberfläche eines von dem Waferträger (422) gehaltenen Wafers (414) angeordnet ist.

3. System (400) mit einem projizierten kardanischen Antriebspunkt nach Anspruch 1, bei dem der kardanische Punkt unterhalb einer Grenzfläche (416) zwischen einem Polierkissen (450) und der Oberfläche eines von dem Waferträger (422) gehaltenen Wafers (414) angeordnet ist.

4. System (400) mit einem projizierten kardanischen Antriebspunkt nach Anspruch 1, bei dem der kardanische Punkt oberhalb einer Grenzfläche (416) zwischen einem Polierkissen (450) und der Oberfläche eines von dem Waferträger (422) gehaltenen Wafers (414) angeordnet ist.

5. System (400) mit einem projizierten kardanischen Antriebspunkt nach Anspruch 1, bei dem die Antriebsschale (428) einen zweiten Satz langgestreckter Schlitze (434, 436) umfasst, der in der konkaven Innenfläche (430) der Antriebsschale angeordnet ist.

6. System mit einem projizierten kardanischen Antriebspunkt nach Anspruch 5, das zusätzlich einen zweiten Satz Antriebskeile (438, 440) umfasst, die sich aus der konvexen kugelförmigen Fläche (420) des Waferträgers (422) hinaus erstrecken.

7. System mit einem projizierten kardanischen Antriebspunkt nach Anspruch 6, bei dem sich der zweite Satz Antriebskeile (438, 440) in den zweiten Satz Antriebsschlitze (434, 436) der Antriebsschale hinein erstreckt.

8. Antriebsschale (428) mit einem projizierten kardanischen Antriebspunkt, **gekennzeichnet durch**
einen ersten Satz langgestreckter Schlitze (442, 444), die in einer konvexen Außenfläche (432) der Antriebsschale angeordnet sind, wobei sich ein erster Satz Antriebskeile (446, 448), die sich aus einer konkaven kugelförmigen Fläche (424) einer Spindel hinaus erstrecken, beim Gebrauch bis in den ersten Satz Schlitze in der Antriebsschale hinein erstreckt; und
einen zweiten Satz langgestreckter Schlitze (434, 436), der in einer konkaven Innenfläche (430) der Antriebsschale angeordnet ist, wobei sich ein zweiter Satz Antriebskeile (438, 440), die sich aus einer konvexen kugelförmigen Fläche (420) eines Waferträgers (422) hinaus erstrecken, beim Gebrauch bis in den zweiten Satz Schlitze in der Antriebsschale hinein erstreckt; und
wobei die Antriebsschale (428) es dem Waferträger (422) ermöglicht, um einen vorbestimmten kardanischen Punkt gekippt zu werden.

9. Antriebsschale (428) mit einem projizierten kardanischen Antriebspunkt nach Anspruch 8, bei der der erste Satz Schlitze (442, 444) zwei langgestreckte Schlitze umfasst.

10. Antriebsschale (428) mit einem projizierten kardanischen Antriebspunkt nach Anspruch 9, bei der die beiden langgestreckten Schlitze des ersten Satzes Schlitze entlang des Umfangs der Antriebsschale ungefähr um 180 Grad getrennt sind.

11. Antriebsschale (428) mit einem projizierten kardanischen Antriebspunkt nach Anspruch 10, bei der der zweite Satz Schlitze (434, 436) zwei langgestreckte Schlitze umfasst.

12. Antriebsschale (428) mit einem projizierten kardanischen Antriebspunkt nach Anspruch 11, bei der die beiden langgestreckten Schlitze des zweiten Satzes Schlitze entlang des Umfangs der Antriebsschale ungefähr um 180 Grad getrennt sind.

13. Antriebsschale (428) mit einem projizierten kardanischen Antriebspunkt nach Anspruch 12, bei der der erste Satz Schlitze um ungefähr 90 Grad um eine Symmetrieachse der Antriebsschale herum versetzt von dem zweiten Satz langgestreckter Schlitze angeordnet ist.

## Revendications

1. Un système d'entraînement (400) de points de cardan projeté, comprenant:
- une broche (412) capable d'appliquer un couple, la broche ayant une surface (424) sphérique concave, formée sur une partie inférieure de la broche (426) et un premier jeu de clavettes d'entraînement (446, 448) s'étendant hors de la surface (424) sphérique concave;
- un support de tranche (422) disposé partiellement à l'intérieur de la partie inférieure de la broche (426), le support de tranche ayant une surface (420) sphérique convexe, formée sur une surface opposée à la surface sphérique concave de la broche (424);
**caractérisé par**
- une coupelle d'entraînement (428) disposée entre la partie inférieure de la broche (426) et le support de tranche (422), la coupelle d'entraînement ayant une surface intérieure (430) concave et une surface extérieure (432) convexe, la coupelle d'entraînement ayant en outre un premier jeu de fentes allongées (442, 444) situées dans la surface extérieure convexe de la coupelle d'entraînement, le premier jeu de clavettes d'entraînement (446, 448) s'étendant dans les fentes allongées, de manière à permettre au support de tranche (422) d'être basculé autour d'un point de cardan prédéfini.

2. Un système d'entraînement (400) de points de cardan projeté, tel qu'indiqué à la revendication 1, dans lequel le point de cardan est situé sur une interface (416) entre un tampon de polissage (450) et une surface d'une tranche (414) maintenue par le support de tranche (422).

3. Un système d'entraînement (400) de points de cardan projeté, tel qu'indiqué à la revendication 1, dans lequel le point de cardan est situé au-dessous d'une interface (413) entre un tampon de polissage (450) et une surface d'une tranche (414) maintenue par le support de tranche (422).

4. Un système d'entraînement (400) de points de cardan projeté, tel qu'indiqué à la revendication 1, dans lequel le point de cardan est situé au-dessus d'une interface (416) entre un tampon de polissage (450) et une surface d'une tranche (414) maintenue par le support de tranche (422).

5. Un système d'entraînement (400) de points de cardan projeté, tel qu'indiqué à la revendication 1, dans lequel la coupelle d'entraînement (428) comprend un deuxième jeu de fentes (434, 436) allongées, situées dans la surface intérieure (430) concave de la coupelle d'entraînement.

6. Un système d'entraînement (400) de points de cardan projeté, tel qu'indiqué à la revendication 5, comprenant en outre un deuxième jeu de clavettes d'entraînement (438, 440) s'étendant hors de la surface (420) sphérique convexe du support de tranche (422).

7. Un système d'entraînement (400) de points de cardan projeté, tel qu'indiqué à la revendication 6, dans lequel le deuxième jeu de clavettes d'entraînement (438, 440) s'étend dans le deuxième jeu de fentes d'entraînement (434, 436) de la coupelle d'entraînement.

8. Une coupelle d'entraînement (428) de point de cardan projeté, **caractérisée par** :
- un premier jeu de fentes (442, 444) allongées, situées dans une surface extérieure (432) convexe de la coupelle d'entraînement, dans laquelle coupelle, en utilisation, un premier jeu de clavettes d'entraînement (446, 448) s'étendant hors d'une surface sphérique concave (424) d'une broche s'étendent dans le premier jeu de fentes ménagées dans la coupelle d'entraînement; et
- un deuxième jeu de fentes (434, 436) allongées, situées dans une surface intérieure (430) concave de la coupelle d'entraînement, dans laquelle coupelle en utilisation, un deuxième jeu de clavettes d'entraînement (438, 440) s'étendant hors d'une surface sphérique (420) convexe d'un support de tranche s'étendent dans le deuxième jeu de fentes de la coupelle d'entraînement; et
- la coupelle d'entraînement (428) permettant au support de tranche (422) d'être basculé autour d'un point de cardan prédéfini.

9. Une coupelle d'entraînement de point de cardan projeté (428), telle qu'indiquée à la revendication 8, dans laquelle le premier jeu de fentes (442, 444) comprend deux fentes allongées.

10. Une coupelle d'entraînement de point de cardan projeté (428), telle qu'indiquée à la revendication 9, dans laquelle les deux fentes allongées du premier jeu de fentes sont séparées d'environ 180 degrés autour de la circonférence de la coupelle d'entraînement.

11. Une coupelle d'entraînement de point de cardan projeté (428), telle qu'indiquée à la revendication 10, dans laquelle le deuxième jeu de fentes (434, 436) comprend deux fentes allongées.

12. Une coupelle d'entraînement de point de cardan projeté (428), telle qu'indiquée à la revendication 11, dans laquelle les deux fentes allongées du deuxième jeu de fentes sont séparées d'environ 180 degrés autour de la circonférence de la coupelle d'entraînement.

13. Une coupelle d'entraînement de point de cardan projeté (428), telle qu'indiquée à la revendication 12, dans laquelle les fentes du premier jeu sont situées à environ 90 degrés autour d'un axe de symétrie de la coupelle d'entraînement par rapport aux fentes allongées du deuxième jeu de fentes.
